# EUROPEAN PATENT APPLICATION

(11) **EP 4 701 080 A1**
(43) Date of publication of application: **25.02.2026**
(21) Application number: 24195191.2
(22) Date of filing: 19.08.2024
(51) Int. Cl.: H03K 17/12, H02M 1/00, H02M 1/08, H03K 17/28, H03K 17/567

(54) **MULTI-LAYER CONTROL METHOD FOR INVERTER USING MOSFET AND SI IGBT HYBRID POWER SEMICONDUCTOR**

(71) Applicant: Volvo Car Corporation, 405 31 Göteborg (SE)
(72) Inventor: ZHANG, Chi, SE-405 31 Göteborg (SE)
(74) Representative: Nederlandsch Octrooibureau

(57) **Abstract**

A method including receiving an inverter output current; estimating, via a loss model, a first junction temperature and a second junction temperature based on the inverter output current; determining a temperature difference between the first junction temperature and the second junction temperature; generating a comparison value based on a comparison between the temperature difference and a temperature difference threshold; determining an operating mode based on the comparison value, wherein the operating mode is defined by an output current amplitude, and wherein the operating mode is associated with a first time difference and a second time difference; adjusting the first time difference to satisfy the temperature difference threshold, wherein the first time difference is a time difference between a time when the first output stage switches on and a time when the second output stage switches on; and adjusting the second time difference to satisfy the temperature difference threshold, wherein the second time difference is a time difference between a time when the first output stage switches off and a time when the second output stage switches off and controlling at least one output gate based on the first time difference and the second time difference.

## Description

### Technical Field

The present disclosure relates to the field of controlling integrated circuits (IC)s, in particular a method of controlling gate drivers for simultaneously or concurrently producing a drive input for both a silicon carbide metal-oxide-semiconductor field-effect transistor (SiC MOSFET) and a silicon insulated-gate bipolar transistor (Si IGBT).

### Background of the Present Disclosure

Semiconductors including different transistors may result in an intolerable junction temperature difference between the different transistors.

SiC MOSFET has increased in popularity due to its fast switching speed, tolerance for a relatively higher junction temperature as compared to Si IGBT, and relatively higher thermal conductivity as compared to Si IGBT. The automotive industry, in particular, has discovered several applications for SiC MOSFET. However, SiC MOSFETs are considerably more costly than Si based power devices such as Si IGBT.

Devices including both SiC MOSFET and Si IGBT devices have been developed to take advantage of the performance of SiC MOSFET devices and offset their costs with comparatively less costly Si IGBT devices.

Using strictly SiC MOSFET devices may unnecessarily incur greater costs. Using strictly Si IGBT devices may lead to undesired performance issues. For example, avoiding performance degradation.

Instead of using strictly Si IGBT devices or strictly SiC MOSFET devices, Si IGBT devices may work in parallel with SiC MOSFET devices. A hybrid semiconductor power module incorporating Si IGBT devices and SiC MOSFET devices in parallel results in a desired on-state resistance.

However, the hybrid semiconductor power module may result in an unbalanced junction temperature because the SiC MOSFET devices and Si IGBT devices are different semiconductor devices and have different temperature tolerances. Therefore, it would be desirable in the field of ICs to provide a method of controlling a gate sequence to provide a drive input for both SiC MOSFET devices and Si IGBT devices of hybrid devices. The method may control the gates of gate drivers to achieve a desired switch loss of a hybrid device.

A method or digital control algorithm may control gate sequence to maintain a temperature difference between the SiC MOSFET(s) and the Si IGBT(s) of the hybrid semiconductor power module within a desired temperature range, thus maintaining a current delivery capability of a power module. The temperature difference between the SiC MOSFET(s) and the Si IGBT(s) of the hybrid semiconductor power module may also be referred to as the junction temperature of the hybrid semiconductor power module.

The background section relating to methods of controlling ICs, in particular in automotive inverter applications, is merely intended to provide a contextual overview of some current issues and is not intended to be exhaustive. Other contextual information may become apparent to a person of skill in the art upon review of the following detailed description.

### Summary of the Disclosure

According to an embodiment, a method may include receiving an inverter output current and estimating, via a loss model, a first junction temperature of a first transistor and a second junction temperature of a second transistor based on the inverter output current. The method may further include determining a temperature difference between the first junction temperature and the second junction temperature; generating a comparison value based on a comparison between the temperature difference and a temperature difference threshold; determining an operating mode based on the comparison value, wherein the operating mode is defined by an output current amplitude, and wherein the operating mode is associated with a first time difference and a second time difference. In response to the above determinations and generations, adjusting the first time difference to satisfy the temperature difference threshold, wherein the first time difference is a time difference between a time when a first output stage switches on and a time when a second output stage switches on, and/or adjusting the second time difference to satisfy the temperature difference threshold, wherein the second time difference is a time difference between a time when the first output stage switches off and a time when the second output stage switches off and controlling at least one output gate based on the first time difference and the second time difference if the comparison value is above a predetermined temperature range; and/or adjusting a first current and/or a second current if the comparison value is within the predetermined temperature range.

Hybrid semiconductor devices require two different voltages. Controlling the different currents of the SiC MOSFET and the Si IGBT of a hybrid device and/or switching the output stage gates maintains an appropriate junction temperature of the hybrid semiconductor device. Therefore, a method may be configured to control one or more gate drivers that control the transmission of two different voltages to a hybrid semiconductor device. the method of the digital control algorithm may be configured to modulate two different voltages to the hybrid semiconductor device without a risk of performance or damage to the hybrid device semiconductor device.

According to an embodiment, the method may further include that the temperature difference is within an allowable operating range, and wherein the operating mode is an ongoing operating mode. When the temperature difference is within the allowable operating range, the hybrid device is operating at a desired performance. Because the hybrid device is operating within a desired performance, the method may continue with its ongoing mode of operation. The desired performance may be defined by several key performance indicators.

According to an embodiment, the method may further include that the temperature difference is outside an allowable operating range, and the operating mode is different than an ongoing operating mode. When the temperature difference is outside the allowable operating range, the hybrid device may be operating at a degraded performance. Because the hybrid device is operating at a degraded performance, the method may further make a determination whether the temperature difference can be corrected with a current alteration or a change in the output stage gates.

If the determination is that the temperature difference can be corrected with a current alteration, a first layer of the method may alter a first current for the SiC MOSFET and/or alter a second current for the Si IGBT.

Alternatively, if the determination is that the temperature difference cannot be corrected with a current alteration, a second layer of the method may alter at least one of the output stage gates.

The steps of altering at least one of the first current and the second current or altering at least one output stage gate reduce the temperature difference to within an allowable temperature difference.

According to an embodiment, the method may further include that controlling the at least one output gate is configured to generate the first time difference and the second time difference between a first output stage and a second stage.

Controlling the first time difference and/or the second time difference controls a difference in time between switching on a first transmitter as compared to switching on a second transmitter. For example, an output stage transmitting a voltage to a SiC MOSFET and a further output stage transmitting a further voltage to a Si IGBT. Managing the time when both transistors of a hybrid semiconductor power module are on at the same time manages the junction temperature of the hybrid semiconductor power module. Maintaining the junction temperature of a hybrid semiconductor power module maintains a desirable operating performance. If the junction temperature rises above a threshold temperature, the semiconductor power module performance may degrade.

According to an embodiment, the method may further include that the first time difference is set to switch on the first output stage and the second output stage at the same time.

According to an embodiment, the method may further include that the first time difference is set to switch on the first output stage before the second output stage.

According to an embodiment, the method may further include that the first time difference is set to switch on the first output stage after the second output stage.

According to an embodiment, the method may further include that the second time difference is set to switch off the first output stage and the second output stage at the same time.

According to an embodiment, the method may further include that the second time difference is set to switch off the first output stage before the second output stage.

According to an embodiment, the method may further include that the second time difference is set to switch off the first output stage after the second output stage.

A hybrid semiconductor power module may be available in different configurations. For example, they may be available with different numbers of SiC MOSFETs and Si IGBTs. For examples a hybrid semiconductor power module may include equal of SiC MOSFETs and Si IGBTs, more SiC MOSFETs than Si IGBTs, or less SiC MOSFETs than Si IGBTs. Different first time differences and different second time differences may be configured for different hybrid semiconductor power module configurations. For example, because SiC MOSFETs may operate at a higher temperature without performance degradation as compared to Si IGBTs, the number of SiC MOSFETs and Si IGBTs may be a factor in determining the first time difference and/or the second time difference.

According to an embodiment, the method may further include increasing a first current.

According to an embodiment, the method may further include decreasing a first current.

According to an embodiment, the method may further include increasing a second current.

According to an embodiment, the method may further include decreasing a second current.

The multi-layer method may determine that the junction temperature of the hybrid semiconductor is above a desired junction temperature, but that adjusting the first time difference and the second time difference is not necessary. If the junction temperature is above an allowable junction temperature, but less than the temperature difference threshold, the method may choose a path of adjusting a first current for a SiC MOSFET and/or a second current for a Si IGBT. Adjusting the first current and/or the second current may be a less resource intensive action than adjusting the output stage gates. Additionally, adjusting the first current and/or the second current may be a faster action than adjusting the output stage gates. Therefore, the multi-layer method can efficiently maintain the hybrid semiconductor power module junction temperature without sacrificing the performance of the hybrid semiconductor power module.

### Brief Description of the Drawings

The disclosure will now be described in further detail with reference to the drawings that shows one embodiment of the present disclosure:
FIG. 1 illustrates a device of a hybrid semiconductor device including at least one Si IGBT and at least one SiC MOSFET in parallel;
FIG. 2 illustrates a comparison chart of on-state voltage of a Si IGBT device, a SiC MOSFET device, and a hybrid (Si IGBT and SiC MOSFET in parallel) device for different currents;
FIG. 3 illustrates a chart of current amplitude of an inverter output current;
FIG. 4 illustrates five possibilities of gate sequences for concurrently providing voltage to a Si IGBT device and a SiC MOSFET device;
FIG. 5 illustrates a control architecture diagram configured to adjust gate drivers to maintain a temperature difference between a Si IGBT and a SiC MOSFET in a hybrid semiconductor power module according to a control method;
FIG. 6 illustrates a proposed flow of a method to control gate driver ICs according to some embodiments;
FIG. 7 illustrates a time difference between two output stages of gate drivers of an IC;
FIG. 8 illustrates a flowchart of a method to control gate drivers of an IC according to some embodiments;

### Detailed Description

The present disclosure is directed to a method of controlling output gates of at least one gate driver. In particular, the method is directed to controlling the output gates to transmit two different drive inputs (voltages) to a hybrid semiconductor power module. For example, a first drive input for a SiC MOSFET and a second drive input for a Si IGBT of a hybrid semiconductor power module. The hybrid semiconductor power module may include a plurality of SiC MOSFETs and a plurality of Si IGBTs. The SiC MOSFETs and the Si IGBTs may be arranged in parallel in the hybrid semiconductor power module.

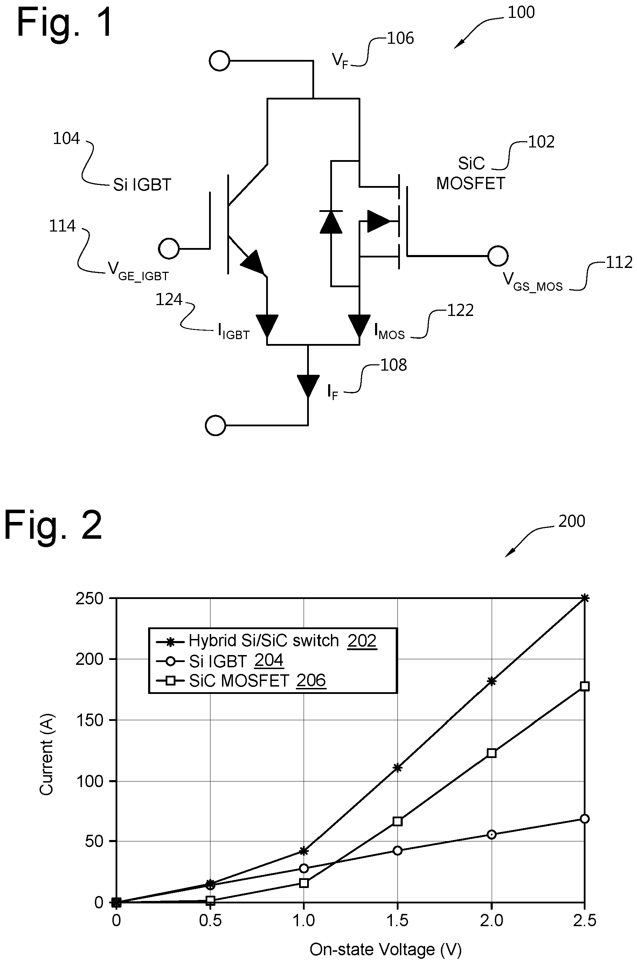

A multi-layer method may control gates to provide two distinct drive inputs to a hybrid semiconductor power module, such as the hybrid semiconductor device of FIG. 1

FIG. 1 is a hybrid semiconductor device 100 including at least one SiC MOSFET 102 and at least one Si IGBT 104 in parallel. The SiC MOSFET 102 may receive MOSFET voltage 112 such as a gate source voltage. Upon receipt of MOSFET voltage 112, such that MOSFET voltage 112 is greater than or equal to a MOSFET threshold of the SiC MOSFET 102, MOSFET current 122 flows through SiC MOSFET 102. The Si IGBT 104 may receive IGBT voltage 114, such that IGBT voltage 114 is greater than or equal to a IGBT threshold of the Si IGBT 104, IGBT current 124 flows through Si IGBT 104. As a result of currents 122 and 124 flowing through their respective transistors, hybrid semiconductor device 100 may generate forward voltage 106 and forward current 108.

Hybrid semiconductor device 100 may include a plurality of SiC MOSFETs 102 and a plurality of Si IGBTs 104. Hybrid semiconductor device 100 may include an equal number of SiC MOSFETs 102 and Si IGBTs 104. Hybrid semiconductor device 100 may include more SiC MOSFETs 102 than Si IGBTs 104. Hybrid semiconductor device 100 may include fewer SiC MOSFETs 102 than Si IGBTs 104.

FIG. 2 illustrates a comparison chart 200 of measured on-state voltage of multiple semiconductor power module devices for different currents. Line 202 illustrates the measured on-state voltage of a hybrid device such as hybrid semiconductor power module device 100. Line 204 illustrates the measured on-state voltage of a strictly IGBT semiconductor power module device. Line 206 illustrates the measured on-state voltage of a strictly MOSFET semiconductor power module device.

As shown in chart 200, line 202 of hybrid Si/SiC device has lower on-state resistance as compared to line 204 of a strictly Si IGBT device and/or line 206 of a strictly SiC MOSFET device at the same current. As load increases, the benefit of the hybrid device becomes evident. Therefore, hybrid Si/SiC devices provide lower conduction power loss when compared to both strictly Si IGBT and strictly SiC MOSFET devices. The switching speed of the SiC MOSFET in combination with gate sequence control between Si IGBT and SiC MOSFET devices of a hybrid device can achieve much lower switching power loss compared to strictly Si IGBT devices. As a result, hybrid devices offer high efficiency and high-power density energy conversion systems as compared to strictly Si IGBT devices without incurring the higher costs of strictly SiC MOSFET devices.

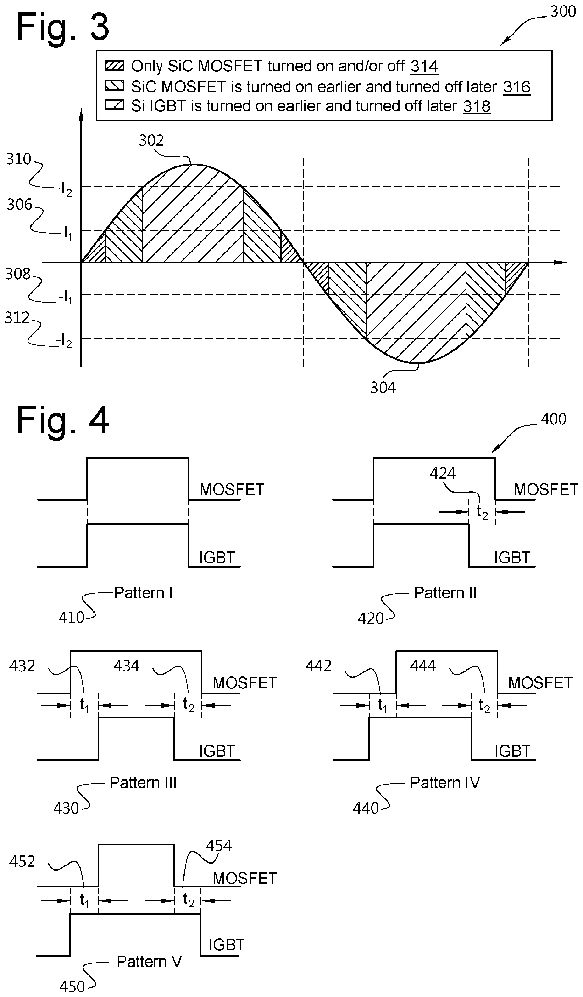

Fig. 3 illustrates an exemplary current cycle chart 300 of an inverter output current of a hybrid semiconductor device, such as hybrid semiconductor device 100. Current cycle 300 may be an alternating current with a positive maximum 302 and a negative maximum 304. Controlling a switch gate may be based on the magnitude of the current. First current positive magnitude 306 and first current negative magnitude 308 may represent a load current of the hybrid semiconductor device. A first current may be represented as having a first current positive magnitude 306 and a first current negative magnitude 308. The first current positive magnitude 306 and first current negative magnitude 308 may represent a safe operating current of the Si IGBT device of the hybrid semiconductor device. A second current may be represented as having a second current positive magnitude 310 and a second current negative magnitude 312. The second current positive magnitude 310 and the second current negative magnitude 312 may represent a safe operating current of the SiC MOSFET device of the hybrid semiconductor device. A method may control one or more gates based the inverter output current of the hybrid semiconductor device.

As shown by area 314, the current may be lower than or equal to the first current positive magnitude 306 and higher than or equal to the first current negative magnitude 308. The method may control one or more gates such that during the time represented by areas 314, only the SiC MOSFET of the hybrid device is turned on and off. During the time represented by areas 314, the Si IGBT of the hybrid device may be in an off state.

As shown by areas 316, the current may be lower than or equal to the magnitude of the second current positive magnitude 310 and higher than or equal to a second current negative magnitude 312. the current may be higher than or equal to the magnitude of the second current positive magnitude 306 and lower than or equal to a second current negative magnitude 308. The method may control one or more gates such that during the time represented by areas 316, the SiC MOSFET of the hybrid device is turned on before turning on the Si IGBT of the hybrid device. During the time represented by areas 316, the SiC MOSFET of the hybrid device is turned off after turning off the Si IGBT of the hybrid device.

As shown by areas 318, the current may be greater than or equal to the magnitude of the second current positive magnitude 310 and lower than or equal to second current negative magnitude 312. The method may control one or more gates such that during the time represented by areas 318, the Si IGBT of the hybrid device is turned on before turning on the SiC MOSFET of the hybrid device. During the time represented by areas 318, the Si IGBT of the hybrid device is turned off after turning off the SiC MOSFET of the hybrid device.

As illustrated by FIG. 3, the method may control the gate sequence between the SiC MOSFET of the hybrid device and the Si IGBT of the hybrid device based on the inverter output current of the hybrid device. The method may determine a gate sequence defined by a time difference between turning on/off the SiC MOSFET of the hybrid device and the Si IGBT of the hybrid device. The gate sequence is explained in further detail with regard to FIG. 4.

FIG. 4 illustrates a sample of available patterns of switching between the SiC MOSFET device and the Si IGBT device of a hybrid semiconductor device. Each pattern may be defined by a time difference between turning on/off the SiC MOSFET device and the Si IGBT device. First pattern 410 may represent a scenario where the method controls one or more gate drivers to turn the SiC MOSFET device and the Si IGBT device on and off at the same time. Said differently, there is no time difference between turning on/off the SiC MOSFET device and the Si IGBT device.

Second pattern 420 may represent a scenario where the method controls one or more gate drivers to turn the SiC MOSFET device and the Si IGBT device on at the same time. However, the method controls one or more gate drivers to turn the SiC MOSFET off after the Si IGBT device. Off time difference 424 represents the amount of time between turning off the Si IGBT device and turning off the SiC MOSFET device. Off time difference 424 may be represented as a positive or negative value depending on the perspective. For example, if off time difference 424 is taken from the perspective of the SiC MOSFET device, off time difference 424 may have a negative value because the time off of the Si IGBT device would be in the past as compared to the time off of the SiC MOSFET device. Alternatively, if the off time difference 424 is take form the perspective of the Si IGBT device, off time difference 424 may have a positive value because the time off of the SiC MOSFET would be in the future as compared to the time off of the Si IGBT device.

Third pattern 430 may represent a scenario where the method controls one or more gate drivers to turn the SiC MOSFET on before the Si IGBT device. Additionally, the method controls one or more gate drivers to turn the SiC MOSFET device off after the Si IGBT device. On time difference 432 represents the amount of time between turning on the SiC MOSFET device and turning on the Si IGBT device. Off time difference 434 represents the amount of time between turning off the Si IGBT device and turning off the SiC MOSFET device. On time difference 432 and off time difference 434 may be represented as a positive or negative value depending on the perspective as previously explained.

Fourth pattern 440 may represent a scenario where the method controls one or more gate drivers to turn the SiC MOSFET on after the Si IGBT device. Additionally, the method controls one or more gate drivers to turn the SiC MOSFET off after the Si IGBT device. On time difference 442 represents the amount of time between turning on the Si IGBT device and turning on the SiC MOSFET device. Off time difference 444 represents the amount of time between turning off the Si IGBT device and turning off the SiC MOSFET device. On time difference 442 and off time difference 444 may be represented as a positive or negative value depending on the perspective as previously explained.

Fifth pattern 450 may represent a scenario where the method controls one or more gate drivers to turn the SiC MOSFET on after the Si IGBT device. Additionally, the method controls one or more gate drivers to turn the SiC MOSFET off before the Si IGBT device. On time difference 452 represents the amount of time between turning on the Si IGBT device and turning on the SiC MOSFET device. Off time difference 454 represents the amount of time between turning off the SiC MOSFET device and turning off the Si IGBT device. On time difference 452 and off time difference 454 may be represented as a positive or negative value depending on the perspective as previously explained.

The on time differences 432, 442, and 452 and off time difference 424, 434, 444, and 454 may be determined to maintain a junction temperature of a hybrid semiconductor device within an allowable range. Said differently, the on time difference and the off time differences maintain a temperature difference between the SiC MOSFET and the Si IGBT of a hybrid semiconductor device with an allowable temperature difference range. It should be noted that other patterns may be available.

The method may control one or more gate driver ICs to implement a gate sequence to deliver a first voltage to the SiC MOSFET device and transmit a second voltage to the Si IGBT device of a hybrid power semiconductor device according to a pattern such as the patterns described with respect to FIG. 4.

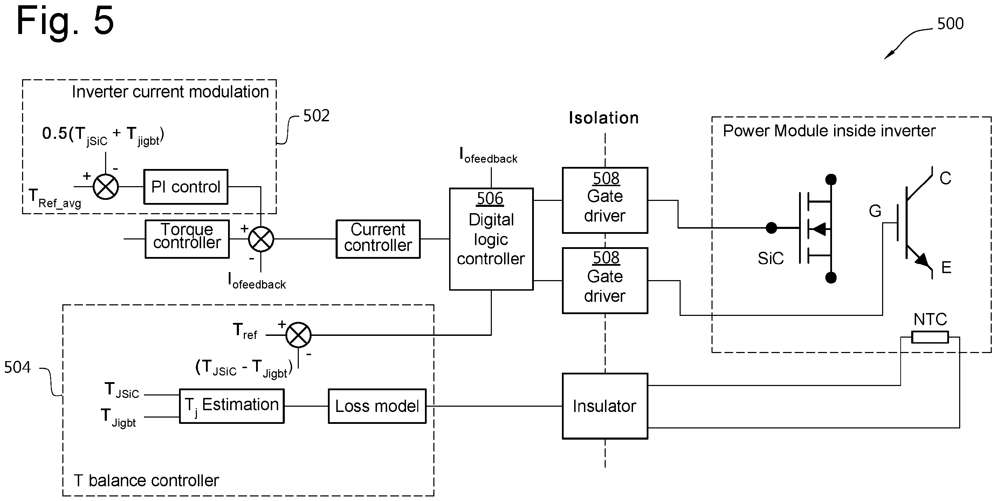

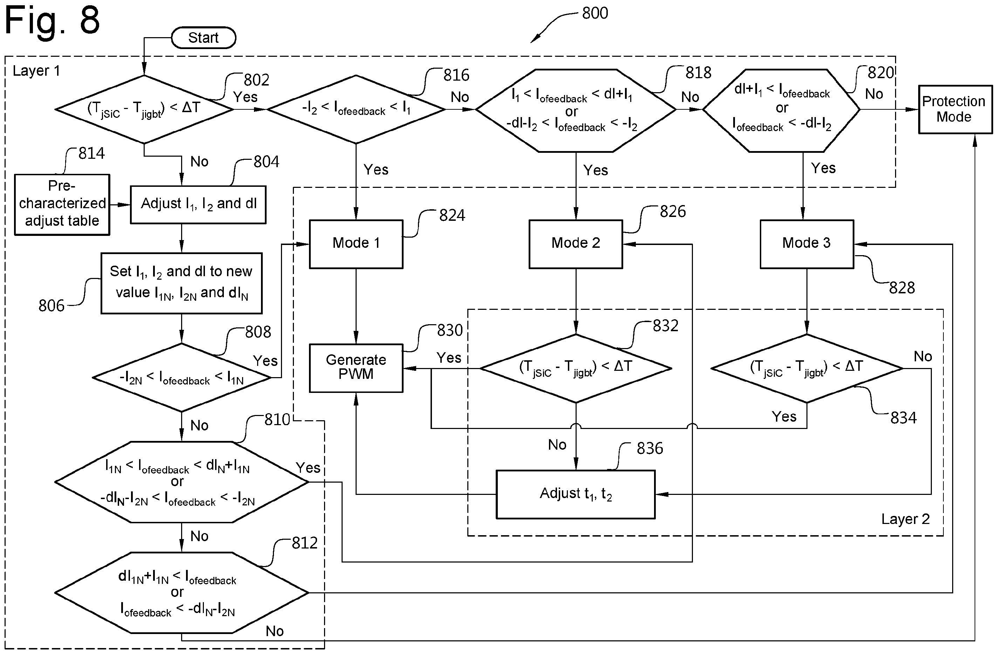

FIG. 5 illustrates a control diagram 500 including a digital logic controller 506 which may store a method. The method may be configured to, when executed by digital logic controller 506, maintain a temperature difference between a Si IGBT and a SiC MOSFET in a hybrid semiconductor power module according to a control method such as the method of FIG. 8.

Control architecture diagram 500 may include temperature balance controller 504. Temperature balance controller 504 may determine the temperature of the Si IGBT and the temperature of the SiC MOSFET of a hybrid semiconductor device. Temperature balance controller 504 may further determine if the difference in temperatures between the Si IGBT and the SiC MOSFET are within an allowable range.

Control architecture diagram 500 may further include current modulator 502 which modulates the inverter output current received from a hybrid semiconductor device.

Digital controller 506 may execute a method of controlling gates of gate drivers 508 based on the determination of temperature balance controller 504 and the current modulation of current modulator 502. The method may be stored in digital controller 506 and connected to gate drivers 508. Digital controller 506 may execute the method to control gates of gate drivers 508 based on the signals from temperature balance controller 504 and current modulator 502. The method may determine a time difference based on the signals from temperature balance controller 504 and current modulator 502. The method may generate a time difference between switching on and/or off at least two gates of gate drivers 508 based on the time difference.

Control architecture diagram 500 may include one or more methods to determine the temperatures and control the gates to generate a desired pattern such as the patterns discussed in FIG. 4.

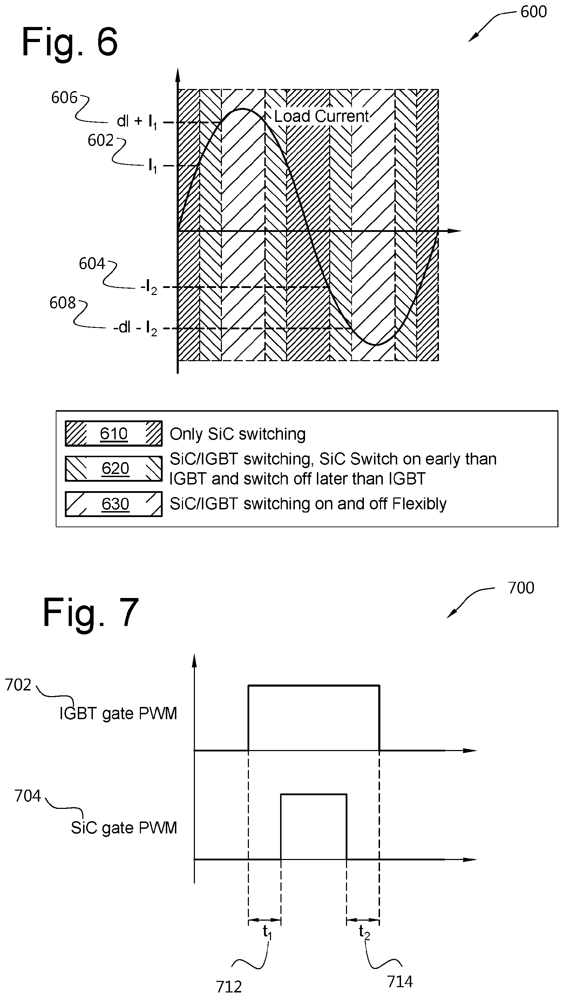

FIG. 6 illustrates a chart 600 of the three different modes of an exemplary multi-layer method, wherein the three different modes are based on the inverter output current. The inverter output current is received from the hybrid semiconductor device and the multi-layer method may control the gate drivers based on the inverter output current. Based on the received information, the multi-layer method may determine a temperature difference between a junction temperature of a SiC MOSFET and a junction temperature of a Si IGBT of hybrid semiconductor device. The temperature difference then may be compared to predetermined values such as a temperature difference threshold. For example, the hybrid semiconductor device may have a maximum allowable difference parameter. If the temperature difference is less than the maximum allowable difference, the multi-layer method may determine that while the hybrid semiconductor device is operating below the maximum allowable difference, performance of the hybrid semiconductor device would benefit from adjusting a first current and or a second current.

The multi-layer method may determine a delta current to add to a first current and/or a second current. For example, first current or second current may be represented by positive current magnitude 602 and negative current magnitude 604. The multi-layer method may determine that in order to maintain the operation performance of hybrid semiconductor device, the first current or the second current requires adjustment by a delta current. Said differently, the method may adjust the first current and/or the second current by an amount determined by a delta current to reduce a temperature difference of a hybrid semiconductor device.

For example, the difference between first current represented by positive current magnitude 602 and negative current magnitude 604 may be adjusted by a delta current to generate positive altered current magnitude 606 and negative altered current magnitude 608. The difference between positive current magnitude 602 and positive altered current magnitude 606 is a value of the delta current. Similarly, the difference between negative current magnitude 604 and negative altered current magnitude 608 is a value of the delta current. The multi-layer method will determine the delta current to define the positive altered first current magnitude 606 and the negative altered first current magnitude.

For example, the multi-layer method may determine the delta current (dl) based on pre-characterized adjustment table. The pre-characterized adjustment table may be stored in a register. The multi-layer method may further determine a working mode based on the inverter output current. The working modes may be similarly stored in a table, where the working modes are based on a relationship between the inverter output current relationship the first current and/or the delta current.

If the difference between the SiC MOSFET and Si IGBT of hybrid semiconductor device is greater than (or equal to) a maximum allowable difference, than the SiC MOSFET and Si IGBT has a temperature difference that cannot be corrected via an adjustment of the first current and/or the second current.

Chart 600 represents three working modes. Mode 610 illustrates a time where the inverter output current is within a normal range and there is no requirement to adjust the working mode. During the area represented by mode 610, the multi-layer method will generate pulse width modulation (PWM) signal according to mode 610. Said differently the pattern of switching will remain the same.

During the time represented by mode 620 and Mode 630, the multi-layer method may determine a relationship between the junction temperature and the maximum allowable temperature difference. if the junction temperature difference is within an allowable range, there is no need to adjust the working mode. If the junction temperature is not in the allowable range, the multi-layer method may adjust the first time difference and/or the second time difference according to a different working mode. Adjusting the first time difference and/or the second time difference will maintain a temperature difference within an allowable range by reducing the time that the SiC MOSFET and the Si IGBT of the hybrid semiconductor device are on at the same time. In this way, the SiC MOSFET which tolerates higher junction temperatures as compared to the Si IGBT, is noton for too long while the Si IGBT is in operation.

FIG. 7 illustrates a switching pattern where the Si IGBT 702 is turned on before the SiC MOSFET 704 and the Si IGBT 702 is turned off after the SiC MOSFET 704. For example, when the while the SiC MOSFET is in operation, it may raise the junction temperature of the hybrid semiconductor device. At some point, the beginning of second time difference 714, the junction temperature of the hybrid semiconductor device may become too high for the Si IGBT to operate without performance degradation. Therefore, the first time difference 712 and the second time difference 714 are defined to maintain the junction temperature of the hybrid semiconductor such that both Si IGBT 702 and SiC MOSFET 704 may operate without degradation.

The time differences 712 and 714 may be relative times between two or more gates of two or more output stages of gate drivers. Pattern 700 may be associated with a working mode, and the multi-layer method is configured to control the gates to generate pattern 700 and transmit a voltage via an output stage. The output stage may delay transmitting a second voltage to a SiC MOSFET 704 until after time difference 712 has past relative to the transmitting the first voltage to a Si IGBT 702. Additionally, the multi-layer method may control the output stage to terminate transmitting a second voltage to a SiC MOSFET 704 before a terminating a first voltage to Si IGBT 702

The multi-layer method may control output stages based on a junction temperature and an inverter output current. modified. For example, the multi-layer method may adjust the first time difference 712 and/or the second time difference 714 based on the inverter output current.

A person of skill in the art will understand that the first time difference and the second time difference may be configured to create many different patterns. For example, where both output stages start and stop transmitting voltages at the same time. The multi-layer method may control output stages such that a first output stage can switch on earlier or later or at the same time compared with a second output stage. The same holds true for switching off. A first output stage can switch off earlier or later or at the same time compared with a second output stage. Any two out of the plurality of output stages can have the same performance when controlled by second controller executing the multi-layer method.

FIG. 8 illustrates an exemplary method 800 to control gate drivers based on received information about a hybrid semiconductor device. Method 800 may include two layers. A first layer may include elements 802-820 to determine if an allowable junction temperature of a hybrid semiconductor device may be maintained with a current adjustment as described with reference to FIG. 6. Intermediate elements 824-830 may be intermediate steps between the first layer and the second layer and determine an operating mode. A second layer may include elements 832-836 to adjust a first time difference and/or a second time difference based on the operating mode.

Steps 808 and 816 correspond to a first operation mode 824. First operation mode 824 corresponds to an operation mode when the inverter output current is within the current magnitudes 602 and 604 as shown in FIG. 6. Therefore, operation mode 824 may correspond to mode 610 of FIG. 6.

Steps 810 and 818 correspond to a second operation mode 826. Second operation mode 826 corresponds to an operation mode when the inverter output current is within the current magnitudes 606 and 602 or current magnitudes 604 and 608 as shown in FIG. 6. Therefore, operation mode 826 may correspond to mode 620 of FIG. 6.

Steps 812 and 820 correspond to a third operation mode 828. Third operation mode 828 corresponds to an operation mode when the inverter output current is greater than current magnitudes 606 and 608 as shown in FIG. 6. Therefore, operation mode 828 may correspond to mode 630 of FIG. 6.

Method 800 proceeds to steps 804, 806, 808, 810, and 812 after determining that the temperature difference of the hybrid semiconductor device is greater than a temperature difference threshold. Method 800 proceeds to steps 816, 818, and 820 after determining that the temperature difference of the hybrid semiconductor device is less than a temperature difference threshold. Method 800 may proceed to either steps 804, 806, 808, 810, and 812 or steps 816, 818, and 820 when the temperature difference is equal to the temperature difference threshold.

Step 802 may compare a hybrid semiconductor temperature difference to a temperature difference threshold, where the hybrid semiconductor temperature difference is a difference between the junction temperature of a Si IGBT and a SiC MOSFET of the hybrid semiconductor.

If the temperature difference is greater than the temperature difference threshold, step 804 determines if can adjust a first current and/or a second current to maintain the temperature difference within an allowable temperature difference. Step 804 will determine a delta current from an adjustment table 814.

Step 806 will adjust the first current and/or the second current by a value of the delta current of the adjustment table as described with respect to FIG. 6.

Steps 808 and 816 determine if the inverter output current is within the current magnitudes. For example, between current magnitudes 602 and 604 as shown in FIG. 6. If so, the current adjustments are enough to maintain the junction temperature of the hybrid semiconductor device within a valid operating temperature and the operation mode is maintained. An adjustment of the first time difference and/or the second time difference is not necessary. Step 830 generates PWM signal according to first operation mode 824.

If steps 808 and 816 determine that the inverter output current is not within current magnitudes 602 and 604, the multi-layer method may proceed to steps 810 and 818 respectively. Steps 810 and 818 determine if the inverter output current is within the adjusted current magnitudes. For example, between magnitudes 606 and 602 or between 604 and 608 as shown in FIG. 6. If so, method 800 determines that operation should proceed according to second operation mode 826 and proceeds to step 832. Step 832 determines if the temperature differences is greater than allowable temperatures difference. If the temperature difference is greater than an allowable temperature difference, the multi-layer method 800 proceeds to step 836. Step 836 adjusts the first time difference and/or the second time difference according to second operation mode 826. After adjusting the first time difference and/or the second time difference at step at step 836 or determining that temperature difference is below a temperature difference threshold, method 800 proceeds to step 830. Step 830 generates PWM signal according to second operation mode 826.

If steps 810 and 818 determine that the inverter output is not within the adjusted current magnitudes 606 and 602 or 604 and 608, method 800 proceeds to steps 812 and 820. Step 812 and 820 determine if the inverter output current is greater than the adjusted current magnitudes. For example, magnitudes 606 and 608 as shown in FIG. 6. If so, method 800 determines that operation should proceed according to third operation mode 828 and proceeds to step 834. Step 834 and step 832 may be combined into one step. Step 834 determines if the temperature differences is greater than allowable temperatures difference. If the temperature difference is greater than an allowable temperature difference, the multi-layer method 800 proceeds to step 836. Step 836 adjusts the first time difference and/or the second time difference according to third operation mode 828. After adjusting the first time difference and/or the second time difference at step at step 836 or determining that temperature difference is below a temperature difference threshold, method 800 proceeds to step 830. Step 830 generates PWM signal according to third operation mode 828.

A person of skill in the art will understand that comparing the inverter output current to the current magnitudes as in steps 808, 810, 812, 816, 818, and 820 may include and equality. For example, when determining if the inverter output current is greater than a current magnitude could be stated as greater than or equal to.

Method 800 may be stored and executed on a micro controller unit (MCU) in communication with one or more gate drivers. The MCU may process a digital signal generated by the method and control the one or more gate drivers based on the instructions generated by method 800.

While the disclosure has been described with reference to exemplary embodiments, it will be understood by those skilled in the art that various changes may be made, and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiments disclosed, but that the disclosure will include all embodiments falling within the scope of the appended claims.

## Claims

1. A method comprising:
receiving an inverter output current;
estimating, via a loss model, a first junction temperature and a second junction temperature based on the inverter output current;
determining a temperature difference between the first junction temperature and the second junction temperature;
generating a comparison value based on a comparison between the temperature difference and a temperature difference threshold;
determining an operating mode based on the comparison value, wherein the operating mode is defined by an output current amplitude, and wherein the operating mode is associated with a first time difference and a second time difference;
adjusting the first time difference to satisfy the temperature difference threshold, wherein the first time difference is a time difference between a time when a first output stage switches on and a time when a second output stage switches on; and
adjusting the second time difference to satisfy the temperature difference threshold, wherein the second time difference is a time difference between a time when the first output stage switches off and a time when the second output stage switches off and controlling at least one output gate based on the first time difference and the second time difference.

2. The method of claim 1 wherein the temperature difference is within an allowable operating range, and wherein the operating mode is an ongoing operating mode.

3. The method of claim 1 wherein the temperature difference is outside an allowable operating range, and the operating mode is different that an ongoing operating mode.

4. The method of claim 3, wherein controlling the at least one output gate is configured to generate the first time difference and the second time difference between the first output stage and the second stage.

5. The method of claim 3 or 4, wherein the first time difference is set to switch on the first output stage and the second output stage at the same time.

6. The method of claim 3, wherein the first time difference is set to switch on the first output stage before the second output stage.

7. The method of claim 3, wherein the first time difference is set to switch on the first output stage after the second output stage.

8. The method of claim 3, wherein the second time difference is set to switch off the first output stage and the second output stage at the same time.

9. The method of claim 3, wherein the second time difference is set to switch off the first output stage before the second output stage.

10. The method of claim 3, wherein the second time difference is set to switch off the first output stage after the second output stage.

11. The method of claim 2, further comprising increasing a first current.

12. The method of claim 2, further comprising decreasing a first current.

13. The method of claim 2, further comprising increasing a second current.

14. The method of claim 2, further comprising decreasing a second current.
